# EUROPÄISCHE PATENTSCHRIFT

(11) **EP 3 116 292 B1**
(45) Veröffentlichungstag und Bekanntmachung des Hinweises auf die Patenterteilung: **17.03.2021**
(21) Anmeldenummer: 15175536.0
(22) Anmeldetag: 06.07.2015
(51) Int. Cl.: H05K 7/20

(54) **ELEKTRONIKMODUL MIT GENERATIV ERZEUGTEM KÜHLKÖRPER**
ELECTRONIC MODULE WITH GENERATIVE COOLING BODY
MODULE ELECTRONIQUE DOTE DE DISSIPATEUR THERMIQUE GENERATIF

(43) Veröffentlichungstag der Anmeldung: 11.01.2017
(73) Patentinhaber: EDAG Engineering AG, 65205 Wiesbaden (DE); Fraunhofer-Gesellschaft zur Förderung der angewandten Forschung e.V., 80686 München (DE)
(72) Erfinder: Spiegel, Alexander, 36452 Zella (DE); Gombert, Madeleine, 36041 Fulda (DE); Hillebrecht, Martin, 36100 Petersberg (DE); Gomez Davila, Blas, 85053 Ingolstadt (DE); Beckmann, Frank, 20253 Hamburg (DE); Emmelmann, Claus, 21220 Seevetal-Horst (DE)
(74) Vertreter: Isarpatent

(56) Entgegenhaltungen:
- EP-A1- 2 709 431
- EP-A1- 2 808 986
- EP-A2- 1 484 954
- US-A1- 2012 085 523

## Beschreibung

Die Erfindung betrifft ein Elektronikmodul mit einem Kühlkörper und Elektronikelementen, die über eine Oberfläche des Kühlkörpers verteilt angeordnet und zur Kühlung mit der Oberfläche thermisch gekoppelt sind. Bei dem Elektronikmodul kann es sich insbesondere um ein On-Board-Ladegerät, einen DC-DC-Wandler oder ein Motorsteuergerät für ein Fahrzeug, bevorzugt ein Elektro- oder Hybridfahrzeug handeln. Ein bevorzugtes Anwendungsgebiet ist der Automobilbau. Die Erfindung zielt insbesondere auf Elektro- und Hybridautomobile ab.

Leistungselektroniken erzeugen hohe Verlustleistungen und bedürfen der Kühlung. Die Elektronikkomponenten werden daher auf einem Kühlkörper angeordnet, der von einem Kühlfluid durchströmt wird.

Bei einem aus der DE 10 2012 200 325 A1 bekannten Elektronikmodul sind Elektronikkomponenten auf einem Kühlkörper angeordnet, der aus zwei Kühlstrukturen gefügt ist. Eine der Kühlstrukturen bildet einen zu einer Seite offenen Aufnahmeraum. Die andere Kühlstruktur ragt mit Kühlfinnen in den Aufnahmeraum hinein, so dass zwischen den Kühlfinnen im Aufnahmeraum Kühlkanäle gebildet werden. Die beiden Teilstrukturen sind mittels Schraubverbindung zum geschlossenen Kühlkörper gefügt.

Aus der DE 10 2013 109 589 B3 ist ebenfalls ein Elektronikmodul mit einem aus zwei Kühlstrukturen gefügten Kühlkörper bekannt. Die Kühlstrukturen sind mittels Schweißverbindung gefügt. Kühlfinnen ragen wie beim Kühlkörper der DE 10 2012 200 325 A1 in gleichmäßiger Anordnung von einer der Kühlstrukturen ab und in einen Aufnahmeraum der anderen Kühlstruktur hinein, so dass das Kühlfluid im Aufnahmeraum gleichmäßig über die Wärmeaustauschfläche verteilt wird.

Die EP 0 838 988 A2 offenbart ein Elektronikmodul mit Elektronikelementen, die zur Kühlung auf einem Kühlkörper angeordnet sind, der eine kastenförmige Kühlstruktur aufweist, die an ihrer von den Elektronikelementen abgewandten Seite von einer Bodenplatte verschlossen wird. Von der Kühlstruktur ragen in hexagonaler Symmetrie angeordnete Zapfen in Richtung auf die Bodenplatte ab. Die Zapfen sind der Anordnung der zu kühlenden Elektronikelemente entsprechend in Zapfengruppen angeordnet. Der durchströmbare Hohlraum wird ferner von einer Zwischenwand in zwei Teilräume unterteilt, die parallel durchströmt werden. Die Zwischenwand ragt ebenfalls von der Kühlstruktur in Richtung auf die Bodenplatte ab. Die Kühlstruktur wird einschließlich Zapfen und Zwischenwand aus einem Metall-Keramik-Kompositmaterial gegossen.

Ein besonders kompaktes Elektronikmodul ist aus der DE 20 2009 007 008 U1 bekannt. Das Elektronikmodul weist wie die zuvor beschriebenen Elektronikmodule einen aus Unterstrukturen gefügten Kühlkörper auf. Das Elektronikmodul zeichnet sich durch einen innerhalb des Moduls geschlossenen Kühlkreislauf und eine auf dem Modul integrierte lüfterbasierte Wärmeabfuhr aus.

Die EP 2 801 512 A1 offenbart ein Kühlkörperhybrid, zu dessen Herstellung an einer vorgefertigten Basisstruktur eine Wärmeaustauschstruktur generativ angeformt wird. In einem Ausführungsbeispiel wird an ein Gehäuse einer Leistungselektronik seitlich eine Wärmeaustauschstruktur generativ angeformt. Die Kühlstruktur weist im Inneren gitterförmige oder zelluläre Wärmeaustauschstrukturen in einem sich regelmäßig wiederholenden Muster auf. Es wird auch erwähnt, dass die Kühlstruktur Kühlkanäle aufweisen kann, um ein Kühlsystem mit vorgegebenem Strömungsverlauf zu bilden.

Die EP 1 484 954 A2 und die US 2012/085523 A1 betreffen jeweils einen Kühlkörper, der von einer Kühlflüssigkeit durchflossen werden kann, um beispielsweise mit dem Kühlkörper verbundene Elektronikteile zu kühlen. Der Kühlkörper umfasst mehrere Flüssigkeitskanäle, die nachträglich in den Kühlkörperrohling zum Beispiel durch Bohren eingebracht werden. Bei den Bohrungen handelt es sich um horizontale und vertikale Durchgangsbohrungen, die im Inneren des Kühlkörpers ein verbundenes Kanalnetz bilden. Alle Bohrungsöffnung, bis auf einen Einlass und einen Auslass, werden geschlossen, so dass durch die geschlossenen Öffnungen keine Kühlflüssigkeit austreten kann.

Die EP 2 709 431 A1 betrifft einen Kühlkörper, der aus einem rahmenförmigen Gehäuse und Einsätzen besteht, die in das Gehäuse eingegeben werden. Die Einsätze umfassen an der in das Gehäuse einzugebenden Seite Kühlrippen. Die Kühlrippen bilden ein Kanalnetz in dem Kühlkörper für eine Kühlflüssigkeit.

Die EP 2 808 986 A1 betrifft einen Kühlkörper für einen Linearmotor, der im 3D-Druck hergestellt werden kann.

Es ist eine Aufgabe der Erfindung, ein Elektronikmodul mit Elektronikkomponenten und einem durchströmbaren Kühlkörper zu schaffen, wobei das Elektronikmodul kompakt baut, die Elektronikelemente effizient gekühlt werden und die Dichtheit des Kühlkörpers gewährleistet ist.

Die Erfindung geht von einem Elektronikmodul mit einem durchströmbaren Kühlkörper und Elektronikelementen, die über eine äußere Oberfläche an einer Oberseite des Kühlkörpers verteilt angeordnet sind, aus. Diese äußere Oberfläche wird im Folgenden als oberseitige Oberfläche bezeichnet. Der Kühlkörper weist der oberseitigen Oberfläche abgewandt gegenüberliegend eine äußere unterseitige Oberfläche auf. Die oberseitige Oberfläche und/oder die unterseitige Oberfläche kann oder können jeweils insbesondere eben und parallel sein, was auch einschließt, dass der Kühlkörper an einer oder an beiden äußeren Oberflächen einen treppenartigen Versatz aufweisen kann. Der Kühlkörper ist in bevorzugten Ausführungen plattenförmig und ist besonders bevorzugt eine Kühlplatte im engeren Sinne, d. h. ein Kühlquader mit einer planen oberseitigen Oberfläche, einer planen unterseitigen Oberfläche sowie planen äußeren Seiten. Dies schließt andererseits jedoch nicht aus, dass der Kühlquader eine oder mehrere taschenförmige oder von einer Oberfläche bis zur anderen Oberfläche erstreckte Durchbrüche oder lokale Einschnitte aufweisen kann.

Die Elektronikelemente sind in einem ersten Layout elektrisch und/oder optisch mittels Leiterbahnen verbunden und zur Kühlung mit der oberseitigen Oberfläche des Kühlkörpers thermisch gekoppelt, jedoch elektrisch vom Kühlkörper isoliert. Weist der Kühlkörper in der oberseitigen Oberfläche eine oder mehrere Ausnehmungen jeweils in Form einer Tasche auf, wird der Boden der jeweiligen Tasche als zur oberseitigen Oberfläche gehörig verstanden. Anstelle oder zusätzlich zu einer oder mehreren taschenförmigen Ausnehmungen kann der Kühlkörper an der oberseitigen Oberfläche auch eine oder mehrere Ausnehmungen jeweils in Form eines Durchbruchs aufweisen. Die optional eine oder optional mehreren Ausnehmungen weist oder weisen jeweils Seitenflächen auf, die von dem umgebenden Bereich der oberseitigen Oberfläche einragen.

Eines oder mehrere der Elektronikelemente kann oder können jeweils in Bezug auf den Kühlkörper über Kopf angeordnet sein. Das jeweilige, über Kopf angeordnete Elektronikelement weist mit seinen elektrischen Kontakten vom Kühlkörper weg. Soweit eines oder mehrere Elektronikelemente über Kopf angeordnet ist oder sind, kann das betreffende Elektronikelement an seiner von den elektrischen Kontakten abgewandte Oberseite direkt mit der oberseitigen Oberfläche des Kühlkörpers thermisch leitend verbunden sein. Weist der Kühlkörper eine oder mehrere Ausnehmungen auf, kann das jeweilige, über Kopf angeordnete Elektronikelement vorteilhafterweise in die Ausnehmung ragen, d.h. in den Kühlkörper vergraben sein. Ragt das jeweilige vergrabene Elektronikelement in eine taschenförmige Ausnehmung, kann es an seiner Oberseite und/oder an einer oder mehreren seiner Seitenflächen thermisch leitend mit dem Boden und/oder einer oder mehreren Seitenflächen der Ausnehmung verbunden sein. Ragt das jeweilige vergrabene Elektronikelement in eine als Durchbruch geformte Ausnehmung des Kühlkörpers, kann es an einer oder mehreren seiner Seitenflächen mit einer oder mehreren Seitenflächen der betreffenden Ausnehmung thermisch leitend verbunden sein.

Die Elektronikelemente können auf einer Leiterplatine angeordnet und diese Leiterplatine kann thermisch leitend mit der oberseitigen Oberfläche des Kühlkörpers verbunden sein. Alternativ können die Elektronikelemente auch direkt auf der oberseitigen Oberfläche angeordnet und wärmeleitend mit der Oberfläche verbunden sein. Es sind auch Ausführungen möglich, in denen eines oder mehrere der Elektronikelemente auf einer Leiterplatine angeordnet und eines oder mehrere andere der Elektronikelemente direkt auf der oberseitigen Oberfläche des Kühlkörpers angeordnet sind. Die thermische Kopplung kann beispielsweise mittels eines Wärmeleitpads verwirklicht sein. Das Wärmeleitpad kann zur Befestigung an der Platine und/oder direkt an Elektronikelementen und zur Befestigung am Kühlkörper beidseits adhäsiv beschichtet sein. Anstelle oder zusätzlich zu einer adhäsiven Beschichtung kann zur Befestigung aber auch ein wärmeleitender Klebstoff aufgetragen werden.

Der Kühlkörper weist einen Einlass für ein Kühlfluid, einen Auslass für das Kühlfluid und ein den Kühlkörper durchziehendes Kanalsystem mit im Inneren des Kühlkörpers verzweigten Kanälen auf. Das Kanalsystem verbindet den Einlass mit dem Auslass.

Nach der Erfindung ist der Kühlkörper ein generativ erzeugter Monolith, d. h. eine im Ganzen in einem Stück generativ erzeugte Einheit. Aufgrund der monolithisch generativen Erzeugung kann das Kanalsystem der topografischen Verteilung der Verlustleistungen und somit der Wärmeerzeugung der Elektronikelemente genauer angepasst werden, als dies bislang, etwa bei einem gegossenen Kühlkörper, möglich ist. Aufgrund der generativ monolithischen Erzeugung ist auch die Abdichtung des Kühlkörpers kein Problem mehr, da der Kühlkörper von vornherein abgesehen von Einlass und Auslass, optional auch einem oder mehreren weiteren Einlässen und/oder Auslässen, als eine in Bezug auf ihre äußeren Oberflächen geschlossene Struktur hergestellt wird. Es entfallen Fertigungsschritte, da keine Kühlkörperteile separat voneinander gefertigt und anschließend gefügt werden müssen. Geometriefehler des Kanalsystems, wie sie bei separater Fertigung und anschließendem Fügen auftreten können, werden ausgeschlossen.

Die Querschnitte der Kanäle können flexibel variiert werden, zum einen von Kanal zu Kanal, zum anderen aber auch über den Verlauf des jeweils gleichen Kanals. In den Kanälen können sehr feine Wärmeleitstrukturen erzeugt werden, in Form von Kühlpins, Kühlfinnen oder auch in Längsrichtung des jeweiligen Kanals langgestreckten Kühlrippen. Die innere Oberfläche ist bei einem, mehreren oder bei sämtlichen Kanälen durch eine bei der generativen Erzeugung geschaffene Strukturierung gegenüber glatten Oberflächen deutlich vergrößert, um den Wärmeübergang pro Flächeneinheit der oberseitigen Oberfläche zu vergrößern und/oder dem Wärmebedarf entsprechend in bestimmten Flächenbereichen zu konzentrieren bzw. zu erhöhen.

Der erfindungsgemäß generativ als Monolith erzeugte Kühlkörper kann im Ergebnis bei gleicher Kühlleistung in kleineren äußeren Abmessungen als ein in herkömmlicher Weise geformter und gefügter Kühlkörper bereitgestellt werden. Der Kühlkörper kann insbesondere in einer geringen Dicke ausgeführt sein, wobei die Dicke parallel zur Draufsicht auf die oberseitige Oberfläche gemessen wird.

Die Erfindung betrifft auch ein Verfahren zur Herstellung eines Kühlkörpers für ein Elektronikmodul, wobei der Kühlkörper einen Einlass für ein Kühlfluid, einen Auslass für das Kühlfluid, ein den Kühlkörper durchziehendes Kanalsystem, eine für das Kühlfluid dichte Deckschicht mit einer äußeren oberseitigen Oberfläche und eine für das Kühlfluid dichte weitere Deckschicht mit einer äußeren unterseitigen Oberfläche. Die oberseitige und/oder die unterseitige Oberfläche kann oder können jeweils plane, zumindest im Wesentlichen glatte Oberflächen sein. Die oberseitige Oberfläche und/oder die unterseitige Oberfläche kann oder können eine oder mehrere Ausnehmungen aufweisen. Die jeweilige Ausnehmung kann als eine in die oberseitige Oberfläche oder die unterseitige Oberfläche eingelassene Tasche oder als ein von der oberseitigen Oberfläche bis zur unterseitigen Oberfläche erstreckter Durchbruch geformt sein. Der Kühlkörper kann insbesondere wie vorstehend beschrieben ausgeführt sein.

Im erfindungsgemäßen Verfahren wird der Kühlkörper im Ganzen generativ durch Auftragen von Metallpulver in Pulverbettschichten und Verfestigen des Metallpulvers der jeweiligen Pulverbettschicht erzeugt. Das Metallpulver wird in der jeweiligen Pulverbettschicht der Geometrie des Kanalsystems, des Einlasses und des Auslasses entsprechend selektiv mittels Energiestrahl, vorzugsweise Laser, verfestigt. Das Metallpulver kann mittels des Energiestrahls zum Verfestigen insbesondere geschmolzen werden. In um das Kanalsystem erstreckten Außenbereichen wird das Metallpulver der jeweiligen Pulverbettschicht der Geometrie der Deckschichten entsprechend selektiv mittels Energiestrahl, vorzugsweise Laser, verfestigt, um das Kanalsystem zwischen den Deckschichten dicht einzuschließen.

Zur Verfestigung des Metallpulvers der jeweiligen Pulverbettschicht wird in ersten Ausführungen des Verfahrens nur ein einziger Energiestrahl, vorzugsweise Laser, eingesetzt. In modifizierten Verfahren können pro Pulverbettschicht oder auch nur in ausgewählten Pulverbettschichten mehrere Energiestrahlen, vorzugsweise Laser, gleichzeitig, also parallel in unterschiedlichen Pulverbettbereichen wirkend, verwendet werden.

In einem ersten Verfahren wird der Kühlkörper liegend erzeugt, indem eine oder mehrere Pulverbettschichten nacheinander jeweils einer der Deckschichten entsprechend ganzflächig mittels Energiestrahl verfestigt wird oder werden, um die eine der Deckschichten zu erhalten. Nach Erzeugung der betreffenden Deckschicht wird das Metallpulver in nachfolgend sukzessive aufgetragenen Pulverbettschichten der Geometrie des Kanalsystems entsprechend selektiv mittels Energiestrahl verfestigt. Anschließend werden die zunächst noch offenen Kanäle über mehrere nacheinander aufgetragene und jeweils selektiv verfestigte Pulverbettschichten geschlossen. In der letzten Phase der generativen Erzeugung wird eine oder werden mehrere dann noch aufgetragene Pulverschichten der anderen Deckschicht entsprechend jeweils ganzflächig verfestigt, um die andere Deckschicht zu erhalten. Der Schichtkörper wird im ersten Verfahren somit von einer Deckschicht aus gesehen in Richtung auf die andere aufgebaut. Der Schichtaufbau erfolgt in Dickenrichtung des Kühlkörpers.

In einem bevorzugten zweiten Verfahren wird der Kühlkörper stehend aufgebaut, indem die beiden genannten Deckschichten sukzessive, Pulverbettschicht für Pulverbettschicht, erzeugt werden. Im zweiten Verfahren wird das Metallpulver in den Pulverbettschichten jeweils in einem dem Querschnitt des Kühlkörpers entsprechenden Pulverstreifen selektiv verfestigt. Das Metallpulver wird zum Erhalt der Deckschichten in den Pulverstreifen jeweils in äußeren Pulverstreifenbereichen der jeweiligen Deckschicht entsprechend und im zwischen den äußeren Pulverstreifenbereichen liegenden zentralen Pulverstreifenbereich der Geometrie des Kanalsystems entsprechend mittels Energiestrahl selektiv verfestigt. Im zweiten Verfahren wird der Kühlkörper Schicht für Schicht sukzessive in eine Flächenrichtung der oberseitigen Oberfläche, d. h. von einer Seitenwand des Kühlkörpers in Richtung auf eine gegenüberliegende Seitenwand aufgebaut.

Der Kühlkörper kann insbesondere aus Kupfer und/oder Aluminium und/oder einer Legierung bestehen, die Kupfer und/oder Aluminium als wesentliche Bestandteile enthält. Der Kühlkörper kann dementsprechend insbesondere ein Kühlkörper nur aus Kupfer oder nur aus Aluminium, aus einer Kupferlegierung, einer Aluminiumlegierung oder einer CuAl-Basislegierung bestehen.

Der generativ erzeugte Werkstoff des Kühlkörpers kann über den gesamten Kühlkörper der chemischen Zusammensetzung nach homogen sein. In Modifikationen kann der generativ erzeugte Werkstoff aber auch ein Gradientenwerkstoff sein. Bei einem aus einem Gradientenwerkstoff bestehenden Kühlkörper kann die chemische Zusammensetzung des Werkstoffs in Draufsicht auf die oberseitige Oberfläche gesehen in eine Längenrichtung und/oder eine Breitenrichtung des Kühlkörpers variieren. Bevorzugter variiert die Werkstoffzusammensetzung parallel zur Draufsicht in Dickenrichtung des Kühlkörpers. Ein Werkstoffgradient kann insbesondere in Richtung des generativen Schichtaufbaus eingestellt werden, indem die chemische Zusammensetzung des Metallpulvers von einer Pulverbettschicht zu einer nächsten verändert wird. Die Zusammensetzung des Metallpulvers kann sukzessive über mehrere Pulverbettschichten verändert werden, grundsätzlich ist aber auch vorstellbar, die Zusammensetzung in einem größeren Sprung nur einmal oder in wenigen Schritten zu ändern. Wird der Kühlkörper wie bevorzugt stehend erzeugt, kann ein Werkstoffgradient ohne weiteres in Fortschrittsrichtung des Schichtaufbaus, von einem Ende der oberseitigen Oberfläche in Richtung auf ein gegenüberliegendes Ende der oberseitigen Oberfläche, variiert werden. Für die Einstellung eines Werkstoffgradienten bevorzugt in Dickenrichtung, also von der oberseitigen Oberfläche in Richtung auf die unterseitige Oberfläche oder in die umgekehrte Richtung, eignet sich eher ein in Dickenrichtung fortschreitender Schichtaufbau, also die Erzeugung des Kühlkörpers liegend dem ersten Verfahren entsprechend.

Vorteilhafte Ausgestaltungen werden auch in den Unteransprüchen und in den Kombinationen der Unteransprüche offenbart.

Nachfolgend werden Ausführungsbeispiele der Erfindung anhand von Figuren erläutert. An den Ausführungsbeispieln offenbar werdende Merkmale bilden jeweils einzeln und in jeder Merkmalskombination die Gegenstände der Ansprüche, die vorstehend erläuterten Ausgestaltungen und auch die Aspekte vorteilhaft weiter. Es zeigen:
- Figur 1: ein Elektronikmodul mit einem Kühlkörper eines ersten Ausführungsbeispiels, der sandwichartig zwischen zwei mit Elektronikelementen bestückten Platinen angeordnet und mit den Elektronikelementen thermisch gekoppelt ist,
- Figur 2: Komponenten des Elektronikmoduls in einer Explosionsdarstellung,
- Figur 3: eine Draufsicht auf eine der Platinen,
- Figur 4: einen Querschnitt des Kühlkörpers,
- Figur 5: den Kühlkörper in einem zur Draufsicht der Figur 3 parallelen Schnitt,
- Figur 6: das Detail E der Figur 4,
- Figur 7: eine isometrische Sicht in ein geöffnetes Gehäuse des Elektronikmoduls mit aufgeschnittenem Kühlkörper,
- Figur 8: das Detail A der Figur 7,
- Figur 9: überlagerte Layouts von Elektronikelementen mit einer topografischen Verteilung von Verlustleistungen der Elektronikelemente,
- Figur 10: ein der topografischen Verteilung der Verlustleistungen angepasstes Kanalsystem des Kühlkörpers in einer ersten Iteration,
- Figur 11: generativ stehend erzeugte Kühlkörper,
- Figur 12: einen Kühlkörper aus einem Gradientenwerkstoff, und
- Figur 13: einen Kühlkörper eines zweiten Ausführungsbeispiels.

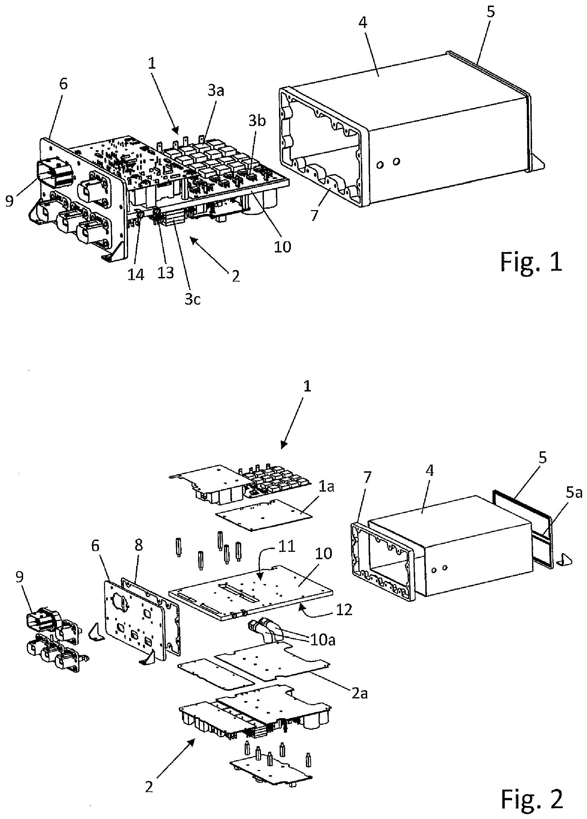

Figur 1 zeigt ein Elektronikmodul unmittelbar vor dem Zusammenbau. Das Elektronikmodul umfasst einen Kühlkörper 10, der sandwichartig zwischen Elektronikelementen 3a und 3b eines ersten Layouts 1 und Elektronikelementen 3c eines zweiten Layouts 2 angeordnet ist, um die Elektronikelemente des jeweiligen Layouts 1 und 2 im Betrieb des Elektronikmoduls zu kühlen. Die Kühlung erfolgt aktiv, indem ein Kühlfluid, vorzugsweise eine Kühlflüssigkeit, durch ein den Kühlkörper 10 im Inneren durchziehendes Kanalsystem gefördert wird. Im Betrieb strömt das Kühlfluid durch einen Einlass 13 des Kühlkörpers 10 in den Kühlkörper 10, durchströmt das innere Kanalsystem und wird durch einen Auslass 14 wieder aus dem Kühlkörper 10 geführt.

Im fertiggestellten Zustand ist der Kühlkörper 10 mit den Elektronikelementen 3a-3c in einem Gehäuse des Elektronikmoduls geschützt aufgenommen. Das Gehäuse kann staub- und wasserdicht und insbesondere so ausgebildet sein, dass es die Anforderungen an ein Gehäuse einer Leistungselektronik im Motorraum eines Elektro-Hybrid- oder reinen Elektrofahrzeugs erfüllt, beispielsweise der Schutzart IP6K6 oder IP6K6K oder IP6K9K entspricht. Das Gehäuse ist aus mehreren separat gefertigten Gehäuseteilen gefügt. Es umfasst ein Gehäusehauptteil 4, das im zusammengebauten Zustand den Kühlkörper 10 mit den Elektronikelementen 3a-3c umgibt, und eine Rückwand 5, die das Gehäusehauptteil 4 an einer Rückseite dicht verschließt. An der Frontseite wird das Gehäusehauptteil 4 im zusammengebauten Zustand von einer Frontwand 6 verschlossen. Die Kühlplatte 10 kann mit der Frontwand 6 fest gefügt sein, so dass im gleichen Montageschritt der Kühlkörper 10 mit den Elektronikelementen 3a-3c in das Gehäusehauptteil 4 eingeschoben und dabei die Frontwand 6 gegen das Gehäusehauptteil 4 geschoben werden kann. Die Frontwand 6 wird im nächsten Schritt mit dem Gehäusehauptteil 4 fest verbunden.

Um den Kühlkörper 10 beim Einschieben zu führen, sind im Bereich des Gehäusehauptteils 4 Führungsstrukturen vorgesehen. Im Ausführungsbeispiel sind Führungsstrukturen zur Führung des Kühlkörpers 10 nur im Frontbereich des Gehäusehauptteils 4 vorgesehen.

Wie in Figur 2 zu erkennen, können die Führungsstrukturen zur Führung der Einschiebeeinheit 6, 10 an einer separat vom Gehäusehauptteil 4 gefertigten, rahmenförmigen Adapterstruktur 7 geformt sein. Die Adapterstruktur 7 ist wie auch die Rückwand 5 mit dem entsprechend vereinfachten Gehäusehauptteil 4 fest gefügt. Die Rückwand 6 und/oder die Adapterstruktur 7 kann oder können jeweils umlaufend stoffschlüssig und dadurch staub- und/oder wasserdicht mit dem Gehäusehauptteil 4 gefügt sein, insbesondere mittels Schweißverbindung, Lötverbindung, oder Klebeverbindung. Die Frontwand 6 wird mit dem Gehäusehauptteil 4 vorzugsweise mittels Schraubverbindung oder Metallklammern verbunden, wobei die Adapterstruktur 7 für das Gehäusehauptteil 4 die zur Herstellung solch einer Verbindung erforderlichen Fügeelemente, bevorzugt Schraubelemente wie insbesondere Schaublöcher, bereitstellt. Die Dichtheit wird durch eine Gehäusedichtung 8 gewährleistet, die im gefügten Zustand zwischen der Adapterstruktur 7 und der Frontwand 6 angeordnet ist.

Das Gehäusehauptteil 4 kann aus einem einfachen Blechzuschnitt durch Kanten und anschließendes Schweißen, Löten oder Kleben kostengünstig in Serie gefertigt werden, falls die Führungsstrukturen zur Führung des Kühlkörpers 10 und/oder die Befestigungselemente zur Befestigung der Frontwand 6 durch eine separat gefertigte Adapterstruktur 7 bereitgestellt werden. Ein Gehäusehauptteil 4 mit integrierten Führungsstrukturen kann beispielsweise durch Strangpressen gefertigt werden. Die optionale Adapterstruktur 7, die bei der Montage dem Positionieren und Führen des Kühlkörpers 10 dient, ist vorzugsweise ein Gussteil, kann aber beispielsweise auch mittels Zerspanen gefertigt werden. Die Rückwand 5 erfüllt vorzugsweise nicht nur die Funktion eines rückseitigen Verschlusses des Gehäuses 4-7, sondern zusätzlich auch noch eine Funktion beim Positionieren und Halten der Kühlplatte 10. Für diese Zweitfunktion kann an der Innenseite der Rückwand 5 eine Positionierstruktur 5a für den Kühlkörper 10 geformt sein, beispielsweise eine Nut oder ein vorstehendes Rippenpaar, in die oder zwischen die der Kühlkörper 10 bei der Montage eingeschoben wird. Die Frontwand 6 kann insbesondere ein gelasertes oder gestanztes Blech, zerspantes Vollmaterial oder ein Gussteil sein. Das gefügte Gehäuse 4-7 ist wie erläutert bevorzugt als Metallgehäuse ausgeführt. Grundsätzlich kann es stattdessen aber auch als Kunststoffgehäuse oder als ein aus Metallteilen und Kunststoffteilen gefügtes Gehäuse ausgeführt sein.

An der Frontwand 6 sind Anschlüsse 9 angeordnet, über die elektrische Energie sowie elektrische und/oder optische Signale zwischen der auf dem Kühlkörper 10 angeordneten Leistungselektronik 3a-3c und einem oder mehreren angeschlossenen Geräten übertragen werden können.

Die Elektronikelemente 3a und 3b des ersten Layouts 1 sind an einer äußeren Oberfläche 11 an einer Oberseite des Kühlkörpers 10 angeordnet. Die Elektronikelemente 3c des zweiten Layouts 2 sind an einer äußeren Oberfläche 12 an einer Unterseite des Kühlkörpers 10 angeordnet. Mit den Begriffen "Oberseite" und "Unterseite" soll lediglich zum Ausdruck gebracht werden, dass der Kühlkörper 10 zwischen dem ersten Layout 1 von Elektronikelementen 3a und 3b und dem zweiten Layout 2 von Elektronikelementen 3c angeordnet ist. Die Begriffe "Oberseite" und "Unterseite" legen die Orientierung des Kühlkörpers 10 im Raum nicht fest.

Der Kühlkörper 10 ist als dünne Kühlplatte und wie bevorzugt zumindest im Wesentlichen als flacher Kühlquader geformt. Der Kühlkörper 10 weist dementsprechend eine Dicke auf, die wesentlich geringer als eine in Draufsicht auf die Oberseite gemessene Länge und Breite ist. Die Länge und die Breite können jeweils mehr als zehnmal so groß wie die Dicke sein. Bevorzugt sind die Länge und die Breite jeweils zwanzigmal so groß wie die Dicke.

Die Elektronikelemente des ersten Layouts 1 sind auf einer Platine angeordnet, die mittels eines Wärmeleitpads 1a wärmeleitend mit der oberseitigen Oberfläche 11 verbunden. Die Elektronikelemente des zweiten Layouts sind ebenfalls auf einer Platine angeordnet und über ein Wärmeleitpad 2a wärmeleitend mit der unterseitigen Oberfläche 12 verbunden. Anstelle jeweils eines Wärmeleitpads 1a und 2a oder einer Wärmeleitfolie oder dergleichen können die Platinen mit den Elektronikelementen 3a bis 3c auch auf andere Weise an der jeweiligen Oberfläche 11 oder 12 befestigt und gut wärmeleitend mit dem Kühlkörper 10 verbunden sein. Gleichwohl sind sie trotz guter thermischen Kopplung vom metallenen Kühlkörper 10 elektrisch isoliert. Andererseits ist auch eine lokale direkte Entwärmung von Spulen über dünn folierte Kupferbleche als partielles Wärmeleitpad zum Kühlkörper 10 hin möglich.

Mit 10a sind in Figur 2 Anschlüsse für die Fluidzufuhr und -abfuhr bezeichnet, ein Anschluss 10a für den Einlass 13 und der andere für den Auslass 14 des Kühlkörper 10 (Figur 1). Der Einlass 13 und der Auslass 14 sind in einer Seitenwand des Kühlkörpers 10 zwischen den Oberflächen 11 und 12 gebildet. Das Gehäusehauptteil 4 weist mit dem Einlass 13 und dem Auslass 14 überlappende Durchgänge auf, durch die die Anschlüsse 10a mit dem Einlass 13 und dem Auslass 14 verbunden und die im montierten Zustand mittels der Anschlüsse 10a abgedichtet werden.

Um die äußeren Abmessungen des Kühlkörpers 10, insbesondere die Abmessungen in Dickenrichtung, bei gegebener Verlustleistung der Elektronikkomponenten 3a-3c gegenüber bekannten Kühlstrukturen zu reduzieren, wird der Kühlkörper 10 generativ monolithisch, d. h. im Ganzen in einem einzigen Stück, erzeugt. Mit der monolithisch generativen Erzeugung eröffnen sich in Bezug auf die Gestaltung eines den Kühlkörper 10 durchziehenden Kanalsystems Möglichkeiten der Optimierung, die konventionelle Fertigungsverfahren nicht bieten. Innerhalb von Kühlkanälen des Kanalsystems können Wärmeleitstrukturen in geringerer Dicke und dadurch größerer Zahl und Oberfläche geschaffen und somit ein intensiverer Wärmeübergang vom Kühlfluid auf den Kühlkörper 10 erhalten werden. In den nachfolgenden Figuren wird ein optimiertes Kanalsystem für eine gerichtete Kühlung der Elektronikelemente 3a-3c anhand eines Beispiels illustriert.

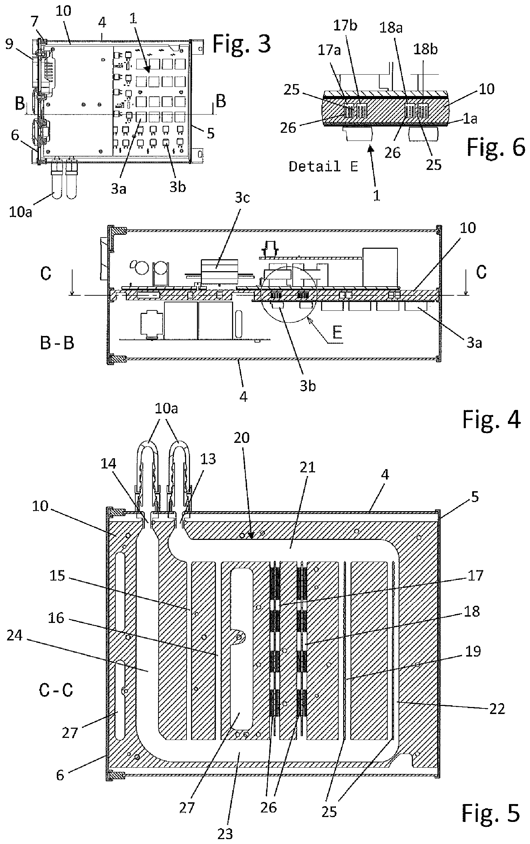

Figur 3 zeigt das Elektronikmodul in einem Schnitt durch das Gehäuse 4-7 und in Draufsicht auf die Elektronikmodule 3a und 3b des ersten Layouts 1 und die oberseitige Oberfläche Streifenabschnitte des unter dem Layout 1 befindlichen Kühlkörpers 10.

Figur 4 zeigt das Elektronikmodul in dem in Figur 3 eingetragenen Schnitt B-B, der insbesondere einen Querschnitt des Kühlkörpers 10 enthält.

Figur 5 zeigt den Kühlkörper 10 in einer zentralen Schnittebene C-C, die in Figur 4 eingetragen ist. Erkennbar ist insbesondere das den Kühlkörper 10 im Innere durchziehende Kanalsystem 20. Das Kanalsystem 20 umfasst einen mit dem Einlass 13 verbundenen ersten Kanal 21 und mehrere stromabwärts des Einlasses 13 vom ersten Kanal 21 abzweigende Kanäle 15-19. Die Kanäle 15-19 erstrecken sich vom ersten Kanal 21 separat voneinander bis in einen mit dem Auslass 14 verbundenen Sammelkanal 23. Der erste Kanal 21 und der Sammelkanal 23 sind Kanalabschnitte eines in einer Schleife durch den Kühlkörper 10 geführten Hauptkanals. Vom ersten Kanal 21 zweigen in Strömungsrichtung fortschreitend ein zweiter Kanal 15, ein dritter Kanal 16, ein vierter Kanal 17, ein fünfter Kanal 18 und ein sechster Kanal 19 ab. Die abzweigenden Kanäle 15-19 sind jeweils gerade und parallel zueinander angeordnet. Die Abstände, die sie in der Draufsicht auf die Schnittebene C-C voneinander aufweisen, können unterschiedlich sein. So ist beispielsweise der Abstand zwischen den Kanälen 15 und 16 kleiner als der Abstand zwischen den Kanälen 16 und 17, und die Kanäle 17 und 18 weisen innerhalb der Gruppe der abzweigenden Kanäle 15-19 den geringsten Abstand voneinander auf.

Der Einlass 13 ist nahe bei dem Auslass 14 an einer Seitenwand des Kühlkörpers 10 gebildet.

Der Hauptkanal erstreckt sich vom Einlass 13 bis zum Auslass 14 in einer Schleife durch den Kühlkörper 10. Der Hauptkanal erstreckt sich nahe bei und beispielhaft parallel zu den Seitenwänden des Kühlkörpers 10. Der Hauptkanal bildet eine äußere Umfangsschleife des Kanalsystems 20. Er weist in Strömungsrichtung gezählt den ersten Kanal 21 als einen ersten Schleifenabschnitt, daran anschließend einen Kanal 22 als zweiten Schleifenabschnitt, an den Kanal 22 als dritten Schleifenabschnitt anschließend den Sammelkanal 23 und an diesen anschließend als vierten Schleifenabschnitt einen Auslasskanal 24 auf. Der erste Kanal 21 und der Sammelkanal 23 verlaufen parallel zueinander. Die Kanäle 22 und 24 verlaufen parallel zueinander und auch parallel zu den abzweigenden Kanälen 15-19.

Der erste Kanal 21 dient als Verteilerkanal. Im Sammelkanal 23 wird das längs des ersten Kanals 21 auf die Kanäle 15-19 verteilte Kühlfluid zusammengeführt und in kontinuierlich an den Sammelkanal 23 sich anschließenden Auslasskanal 24 zum Auslass 14 und über den Auslass 14 abgeführt. Der Kanal 22 verbindet den ersten Kanal 21 mit dem Sammelkanal 23. Die Kanäle 22 und 24 können wie die abzweigenden Kanälen 15-19 insbesondere unterhalb von Elektronikelementen des ersten Layouts 1 und/oder Elektronikelementen des zweiten Layouts 2 verlaufen. Bevorzugt erstrecken sie sich zumindest in Überlappung mit den zu kühlenden Elektronikelementen 3a-3c. Zweckmäßigerweise erstrecken sich auch der erste Kanal 21 und der Sammelkanal 23 in Überlappung mit zu kühlenden Elektronikelementen des ersten Layouts 1 und/oder des zweiten Layouts 2.

Die Querschnitte der Kanäle 15-19 und 21-24 und auch die in der Draufsicht bzw. Schnittebene C-C gemessenen Abstände zwischen nächstbenachbarten Kanälen 15-19, 22 und 24 sind der Funktion des jeweiligen Kanals angepasst. Die abzweigenden Kanäle 15 bis 19 und der Verbindungskanal 24 sind in Bezug auf ihre Abstände und Strömungsquerschnitte an die topografische Verteilung der Verlustleistungen der Elektronikelemente 3a-3c angepasst. Grundsätzlich gilt dies auch für den Kanal 24, der allerdings über die Funktion nur des Kühlens hinaus auch seiner Abführfunktion wegen einen größeren Querschnitt als die Kanäle 15 bis 19 und 22 hat. Das Gleiche gilt für den ersten Kanal 21, der neben einer Kühlfunktion insbesondere die Verteilfunktion erfüllt, und den Sammelkanal 23, der neben einer Kühlfunktion die Sammelfunktion erfüllt.

In Flächenbereichen, in denen keine Elektronikelemente angeordnet oder die Verlustleistungen der im jeweiligen Flächenbereich angeordneten Elektronikelemente 3a-3c nur gering sind, kann der Kühlkörper 10 Ausnehmungen 27 aufweisen. Eine oder mehrere Ausnehmungen 27 können taschenförmige Vertiefungen oder Aussparungen oder, wie im Ausführungsbeispiel, Durchbrüche sein. Das Gewicht des Kühlkörpers 10 kann dem Volumen der jeweiligen Ausnehmung 27 entsprechend gegenüber einem überall vollen Kühlkörper 10 reduziert werden. Eine Gewichtsreduzierung ist in vielen Anwendungen, insbesondere im Automobilbau, von Vorteil. Nicht zuletzt der generativen Fertigung wegen kann eine Ausnehmung 27, wie im Beispiel, oder können mehrere Ausnehmungen zwischen benachbarten Kanälen des Kanalsystems 20 vorgesehen sein, wobei eine oder mehrere dieser zwischen benachbarten Kanälen platzierten Ausnehmungen in einer zur Draufsicht auf die oberseitige Oberfläche 11 orthogonalen Projektion mit den nächstbenachbarten Kanälen überlappen, vorzugsweise jeweils als ein Durchgang gebildet sein können.

Die generative Fertigung hat nicht nur den Vorteil, dass einer oder mehrere Kanäle des Kanalsystems 20 mit kleinem Kanalquerschnitt und/oder einem schlitzförmigen Querschnitt erzeugt werden kann. Innerhalb eines oder mehrerer der Kanäle 15-19 und 21-24, insbesondere in den abzweigenden Kanälen 15-19 und dem Verbindungskanal 22, können vorteilhafterweise schmale Wärmeleitstrukturen erzeugt und dadurch die mit dem Kühlfluid in Kontakt stehende Wärmeaustauschfläche des jeweiligen Kanals deutlich vergrößert werden. Nächstbenachbarte Kanäle können beispielsweise durch extrem dünne Trennwände voneinander getrennt sein. So sind beispielhaft die Kanäle 17, 18, 19 und 22 jeweils als Doppelkanäle ausgebildet, indem sie über wenigstens den überwiegenden Teil der jeweiligen Kanallänge, im Ausführungsbeispiel über die jeweils gesamte Kanallänge, mittels einer dünnen Trennwand 25 voneinander separiert sind. Die Einzelkanäle können beim jeweiligen Doppelkanal 17, 18, 19 und/oder 22 den gleichen Kanalquerschnitt aufweisen, was die rechnerische Auslegung des Kanalsystems 20 erleichtert. Grundsätzlich können sich aber auch die Einzelkanäle des jeweiligen Doppelkanals dem Kanalquerschnitt nach voneinander unterscheiden. Das Kanalsystem 20 kann einen oder mehrere Dreifach- und/oder Vierfach-Kanäle und grundsätzlich eine beliebige Anzahl von unmittelbar nebeneinander angeordneten und durch jeweils eine dünne Trennwand 25 voneinander separierten Kanälen in der Art der Doppelkanäle 17, 18, 19 und 22 aufweisen. Die abzweigenden Kanäle 15-19 müssen nicht geradlinig verlaufen, obgleich ein gerader Verlauf bevorzugt wird, sondern können auch Formen wie Kurven, Schleifen oder abgewinkelte Bahnen annehmen.

In den Kanälen 17 und 18 sind ferner über die jeweilige Kanallänge gesehen lokal nur erstreckte Kühlfinnen 26 angeordnet. Derartig lokalisierte Wärmeleitstrukturen sind zweckmäßigerweise unterhalb von Elektronikelementen geformt, die eine im Vergleich zu anderen Elektronikelementen höhere Verlustleistung erzeugen.

Wie die Zusammenschau der Figuren 3 bis 5 zeigt, sind die eine in Breitenrichtung des Kühlkörpers 10 erstreckten Kanäle 15-19, 22 und 24 jeweils in Überlappung mit Elektronikelementen 3a und 3b des ersten Layouts 1 und/oder Elektronikelementen 3c des zweiten Layouts 2 angeordnet, um die Verlustleistung auf kurzem Weg vom jeweiligen Elektronikelement in das Kühlfluid zu übertragen und mittels des Kanalsystems 20 aus dem Kühlkörper 10 abzuführen. Die Elektronikelemente 3a-3c sind dem jeweiligen Layout 1 oder 2 entsprechend in Arrays angeordnet. Der Verlauf der Kanäle des Kanalsystems 20 ist der jeweiligen Array-Anordnung angepasst, indem sich der erste Kanal 21 und der Sammelkanal 23 unter äußeren Zeilen von Elektronikelementen 3a-3c und die Kanäle 15-19, 22 und 24 unter Spalten von Elektronikelementen 3a-3c erstrecken.

Im Querschnitt der Figur 4 ist der den Spalten der beiden Layouts 1 und 2 folgende Verlauf von Kanälen erkennbar.

Figur 6 zeigt das Detail E der Figur 4, nämlich den Bereich um die beiden Doppelkanäle 17 und 18, die mittels jeweils einer dünnen Trennwand 25 gebildet sind. Die den Doppelkanal 17 bildenden Einzelkanäle sind mit 17a und 17b und die den Doppelkanal 18 bildenden Einzelkanäle sind mit 18a und 18b bezeichnet. Im Querschnitt der Figur 6 sind ferner dünne Kühlfinnen 26 erkennbar, die in jedem der Einzelkanäle 17a-18b geformt sind. Die Kühlfinnen 26 ragen von einer inneren Kanaloberfläche in den Querschnitt des jeweiligen Kanals 17a-18b hinein und vergrößern im jeweiligen Kanalquerschnitt dessen Wärmeaustauschfläche.

Die Trennwände 25 und/oder die Kühlfinnen 26 und/oder anders geformte, in den jeweiligen Kanal hinein ragende Wärmeleitstrukturen können aufgrund der generativen Erzeugung des Kühlkörpers 10 sehr filigran sein. So können Wärmeleitstrukturen, wie etwa die Strukturen 25 und 26, vorteilhafterweise über eine Länge von 1 cm und mehr in einer Dicke von weniger als 1 mm ausgeführt sein. In bevorzugten Ausführungen sind die Wärmeleitstrukturen 25 und 26 höchstens 0.5 mm dick.

In der nachstehenden Tabelle sind bevorzugte Abmessungen eines Kühlkörpers 10 in Form bevorzugter Bereiche zusammengefasst. In Klammern werden ferner besonders bevorzugte Bereiche angegeben. Der jeweilige Kühlkörper 10 kann sämtlichen Längenmaßbereichen der Tabelle entsprechen. Alternativ kann beim jeweiligen Kühlkörper 10 aber auch jede Unterkombination nur verwirklicht sein.

| Längenmaß | bevorzugte Bereiche |
|---|---|
| Länge | 100-500 mm (100-300 mm) |
| Breite | 100-500 mm (100-300 mm) |
| Dicke | 3-20 mm (3-10 mm) |
| Kanalquerschnitt | |
| Querschnittsbreite | 2-15 mm (2-10 mm) |
| Querschnittshöhe | 1-15 mm (1-8 mm) |
| Dicke von Trennwänden 25 | 0,2-1 mm (0,2-0,5 mm) |
| Dicke von inneren Wärmeleitstrukturen, beispielsweise Kühlfinns 26 | 0,2-1_mm (0,2-0,5 mm) |

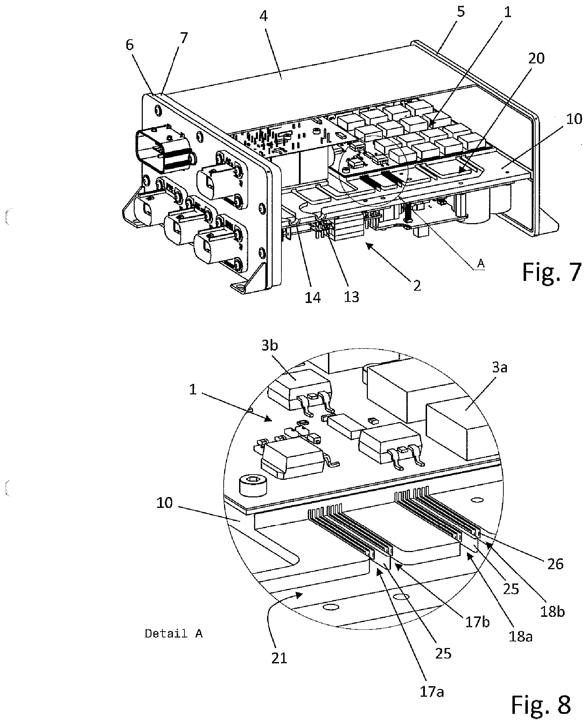

Figur 7 zeigt das Elektronikmodul im fertig montierten Zustand. Vom Gehäusehauptteil 4 ist nur ein kleiner Bereich dargestellt, so dass der Blick auf den Kühlkörper 10 und die Leistungselektronik 1, 2 frei ist. Vom Kühlkörper 10 ist ebenfalls ein Teil weggeschnitten, so dass ein Teilbereich des Kanalsystems 20 freiliegt.

In Figur 8, dem Detail A aus Fig. 7, ist der Bereich des Kanalsystems 20, in dem die Doppelkanäle 17 und 18 (Figur 5) vom ersten Kanal 21 abzweigen, vergrößert dargestellt. Deutlich zu erkennen sind die Trennwände 25, die sich über die gesamte Länge des jeweiligen Doppelkanals 17 und 18 und somit bis in den jeweiligen Mündungsbereich zum Kanal 21 erstrecken. Ebenso sind die im jeweiligen Einzelkanal 17a-18b geformten Kühlfinnen 26 erkennbar. Die Trennwände 25 und Kühlfinnen 26 bilden für das Kühlfluid einen Fächer mit einer nach der Auffächerung parallelen Strömungsführung, wodurch die Wärmeaustauschfläche im jeweiligen Kanal stark vergrößert, der Strömungswiderstand jedoch gering gehalten wird, da die Wärmeleitstrukturen 25 und 26 über den weit überwiegenden Teil ihrer Wärmeaustauschflächen nur in Kanallängsrichtung, also parallel zur Kanallängsrichtung erstreckt sind.

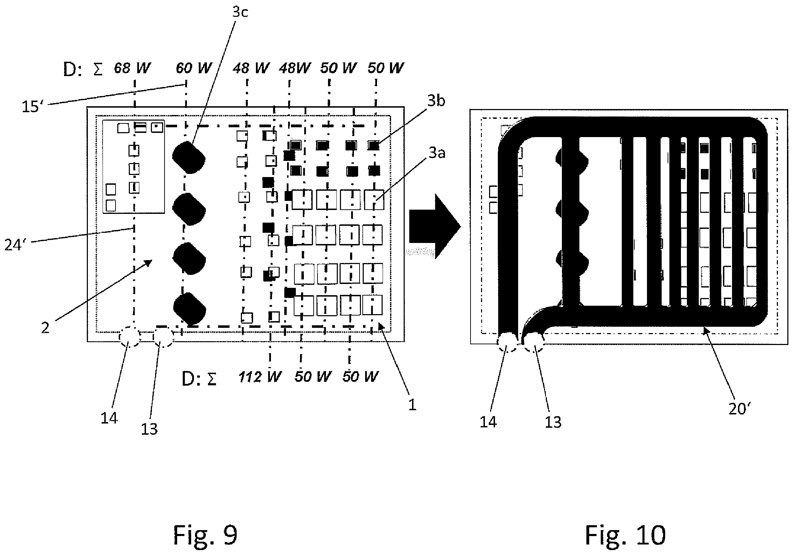

Die Figuren 9 und 10 illustrieren einen ersten Iterationsschritt einer computergestützten Auslegung des Kanalsystems 20. Im ersten Iterationsschritt werden die Layouts 1 und 2 durch Projektion in eine gemeinsame Bildebene überlagert. Für die Überlagerung wird eine topografische Verteilung der Verlustleistungen der Elektronikelemente 3a bis 3c ermittelt. Die Leistungselektronik 1, 2 des Ausführungsbeispiels umfasst weitere Elektronikelemente, die in Figur 9 erkennbar, aber nicht mit eigenen Bezugszeichen versehen sind. Die Elektronikelemente 3a-3c stehen stellvertretend auch für diese weiteren Elektronikelemente. Im Beispiel wird die topografische Verteilung der Verlustleistungen, die jeweilige Dissipation D, spaltenweise für die Überlagerung der jeweils in einem Array angeordneten Elektronikelemente der Layouts 1 und 2 ermittelt. In Figur 9 sind beispielhaft Werte in Watt für die Dissipation pro Spalte der überlagerten Layouts 1 und 2 angegeben. So sind beispielhaft in der äußeren linken Spalte 68 W und in der äußeren rechten Spalte 50 W sowie in einer dazwischenliegenden Spalte als Spitzenwert 112 W abzuführen.

In der ersten Iteration wird für jede der Spalten der Überlagerung der Layouts 1 und 2 ein Kanal vorgesehen, so dass das Kanalsystem 20' der ersten Iteration parallel nebeneinander Kanäle in einer Anzahl aufweist, die der Anzahl der Spalten der Layouts 1 und 2 entspricht. Die Querschnitte der Kanäle werden in Abhängigkeit von der pro Spalte abzuführenden Verlustleistung bemessen. Bei der Dimensionierung der Kanalquerschnitte werden auch die Abstände zwischen jeweils nächstbenachbarten Spalten berücksichtigt. So ergibt sich beispielsweise für den der Spalte mit der größten Verlustleistung folgenden Kanal zwar ein größerer Querschnitt als für andere Kanäle, aufgrund der nahen Nachbarschaft zu weiteren Kanälen ist der Querschnitt des Kanals jedoch kleiner als es einer Proportionalität in Bezug auf die Verlustleistungen entsprechen würde.

In nachfolgenden Iterationsschritten wird das Kanalsystem 20 in Bezug auf die Anzahl der Kanäle, die Abstände zwischen den Kanälen, den Querschnitt des jeweiligen Kanals und die Anordnung von inneren Wärmeleitstrukturen optimiert. Die Optimierung kann insbesondere unter der Maßgabe vorgenommen werden, dass die Bandbreite eines Temperaturbereichs, in den die Elektronikelemente 3a-3c mittels des Kühlkörpers 10 gekühlt werden, ein Minimum annimmt oder einem Minimum nahekommt. Werden die Elektronikelemente 3a-3c durch die Auslegung des Kanalsystems 20 so gekühlt, dass ihre Betriebstemperaturen trotz voneinander abweichenden Verlustleistungen nahe beieinander liegen, kann das Zeitintervall bis zu einem ersten oder nächsten auf Überhitzung beruhenden Ausfall eines der Elektronikelemente 3a-3c maximiert werden. Das Kanalsystem 20 ist das Ergebnis der Optimierung. Das Kanalsystem 20 kann insbesondere nach dem Hardy Cross Verfahren ausgelegt werden.

Das Kanalsystem 20 wird vorteilhafterweise so gestaltet, dass das Kühlfluid trotz kleiner Kanalquerschnitte mit einer so hohen Durchflussrate durch das Kanalsystem 20 gefördert werden kann, dass die Temperaturdifferenz zwischen dem Einlass 13 und dem Auslass 14 klein ist, um einen homogenen Betriebs- und Kühlungszustand, ohne lokale Wärmenester (Hot-Spots), zu erzielen. Die Temperaturdifferenz zwischen Ein- und Auslass ist vorzugsweise kleiner als 5°C, bevorzugter ist sie kleiner als 2°C.

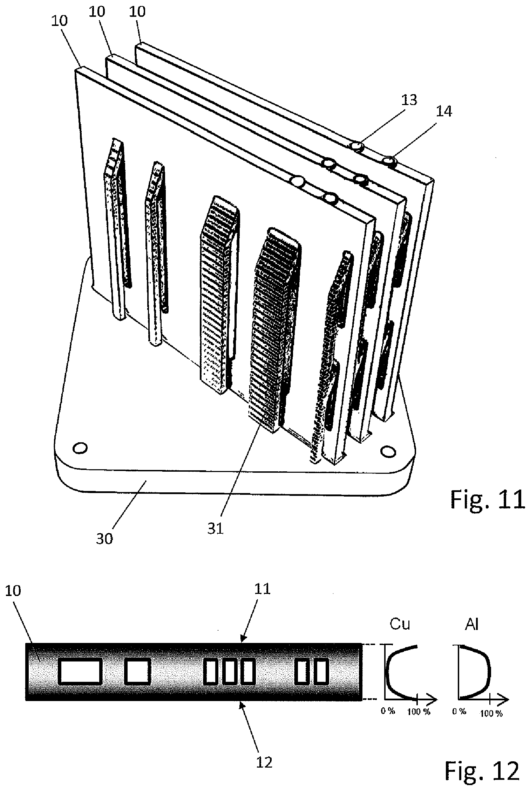

Figur 11 zeigt mehrere der Kühlkörper 10, die jeweils monolithisch generativ nebeneinander stehend erzeugt wurden. Die Kühlkörper 10 können insbesondere parallel, d. h. zeitgleich, nebeneinander erzeugt werden. Die Kühlkörper 10 bestehen aus jeweils einem Metallwerkstoff, beispielsweise aus Kupfer oder Aluminium, einer Cu-Legierung oder Al-Legierung oder einer CuAI-Legierung, die ein oder mehrere weitere Legierungselemente enthalten kann.

Der Kühlkörper 10, oder im Beispiel die mehreren Kühlkörper 10, werden schichtweise aus Metallpulver selektiv mittels Energiestrahl erzeugt, vorzugsweise durch Schmelzen. Als Energiestrahl kommt zwar grundsätzlich auch ein Elektronikstrahl in Frage, bevorzugt wird der Kühlkörper 10 jedoch mittels Laser, besonders bevorzugt mittels Laserschmelzen, erzeugt. Die typische Schichtstärke beträgt 30 bis 60 µm, worauf die Erfindung jedoch nicht festgelegt ist.

Bei der generativen Erzeugung wird das Metallpulver schichtweise aufgetragen, zweckmäßigerweise jeweils in Form eines Pulverbetts. Wegen des stehenden Aufbaus wird das Metallpulver in den Pulverbettschichten jeweils dem Querschnitt des Kühlkörpers entsprechend in einem schmalen Pulverstreifen verfestigt. In den Pulverbettschichten wird das Metallpulver in äußeren Pulverstreifenbereichen, die im fertigen Kühlkörper 10 die oberseitige Oberfläche 11 und die unterseitige Oberfläche 12 (Figur 2) bilden, jeweils dem Verlauf der Deckschicht entsprechend verfestigt. In den Streifenaußenbereichen wird das Metallpulver über die Länge des jeweiligen Streifens durchgängig verfestigt, soweit der jeweilige Pulverstreifen sich nicht über einen optionalen Durchbruch des Kühlkörpers erstreckt. Jedenfalls werden die Pulverstreifen in den Streifenaußenbereichen so verfestigt, dass das Kanalsystem 20 in Bezug auf das Kühlfluid dicht verschlossen wird. Die Verfestigung kann mit einem einzigen Energiestrahl oder auch zeitgleich mit mehreren nebeneinander wirkenden Energiestrahlen verwirklicht werden. Im zentralen Pulverstreifenbereich zwischen den beiden äußeren Pulverstreifenbereichen, die im zu schaffenden Kühlkörper die Oberflächen 11 und 12 bilden, wird das Metallpulver der Geometrie des Kanalsystems 20 entsprechend verfestigt. Ergebnis der generativen Fertigung ist ein Kühlkörper 10 mit dem Einlass 13, dem Auslass 14 und dem inneren Kanalsystem 20, das nur über den Einlass 13 und den Auslass 14 mit der Umgebung verbunden, ansonsten aber im Kühlkörper 10 dicht verkapselt ist. Die Dichtheit des Kanalsystems 20 kann mit einer gegenüber dem Stand der Technik deutlich erhöhten Sicherheit gewährleistet werden. Es bedarf nur noch des Anschlusses an einen Kühlkreislauf.

In Figur 11 ist mit 30 eine Auflage bezeichnet, auf der die Kühlkörper 10 stehend erzeugt wurden. Wegen der geringen Dicke der Kühlkörper 10 werden mit den Kühlkörpern 10 gleichzeitig generativ auch Stützstrukturen 31 erzeugt, welche die Kühlkörper 10 seitlich stützen, insbesondere jeweils im oberen Bereich. Die Stützstrukturen 31 werden anschließend beseitigt. Die Kühlkörper 10 werden von der gemeinsamen Auflage 30 getrennt, beispielsweise mittels Drahterodieren.

Im Ausführungsbeispiel weist das Kanalsystem 20 nur Kanäle auf, die in Draufsicht auf die obenseitige Oberfläche 11 versetzt und/oder winkelig zueinander angeordnet sind. Dies ist nicht zuletzt darauf zurückzuführen, dass die Layouts 1 und 2 bei der Auslegung des Kanalsystems 20 durch Projektion in eine gemeinsame Ebene überlagert wurden. In einer Variation kann der Kühlkörper 10 ein Kanalsystem aufweisen, das Kanäle umfasst, die in der Draufsicht auf die oberseitige Oberfläche 11 relativ zueinander einen Versatz aufweisen und/oder winkelig zueinander stehen, und Kanäle, die in Dickenrichtung des Kühlkörpers 10 zueinander versetzt sind und/oder winkelig zueinander weisen. Die Kanäle des Kanalsystems wären in derartigen Modifikationen nicht zweidimensional, sondern dreidimensional angeordnet. Ein derart modifizierter Kühlkörper 10 kann beispielsweise Kanäle in einer oberen Kanalebene aufweisen, die der Kühlung primär von Elektronikelementen des Layouts 1 dienen, und kann ferner Kanäle in einer unteren Kanalebene aufweisen, die primär der Kühlung von Elektronikelementen des Layouts 2 dienen. Ein oder mehrere Kanäle einer oberen Kanalebene kann oder können jeweils in Überlappung mit einem oder mehreren Kanälen einer unteren Kanalebene verlaufen, optional auch in einer vollständigen Überdeckung übereinander. Ein oder mehrere Kanäle der oberen Kanalebene kann oder können jeweils stattdessen oder zusätzlich auch in der Draufsicht auf die oberseitige Oberfläche 11 versetzt zu einem oder mehreren Kanälen einer unteren Kanalebene erstreckt sein.

In Figur 12 ist ein Kühlkörper 10 aus einem Gradientenwerkstoff schematisch dargestellt. Die oberseitige Oberfläche 11 und die unterseitige Oberfläche 12 bestehen jeweils aus reinem Kupfer. In einem Kernbereich zwischen den Oberflächen 11 und 12 besteht der Kühlkörper 10 aus reinem Aluminium. Vom Kernbereich variiert die chemische Zusammensetzung des Gradientenwerkstoffs in Richtung auf jede der Oberflächen 11 und 12 quasi kontinuierlich, d. h. der Kühlkörperwerkstoff verändert sich von reinem Aluminium über CuAI-Legierungen mit abnehmendem AI-Gehalt und zunehmendem Cu-Gehalt auf reines Kupfer. Die generative Erzeugung eignet sich in besonderer Weise zur Einstellung eines derartigen Werkstoffgradienten in Dickenrichtung, wobei der Kühlkörper 10 für die Einstellung eines Werkstoffgradienten in Dickenrichtung zweckmäßigerweise liegend erzeugt wird. Wird der Kühlkörper 10 wie bevorzugt generativ stehend erzeugt, wie in Figur 11 illustriert, kann ein Werkstoffgradient am Einfachsten in Höhenrichtung des stehenden Kühlkörpers 10 eingestellt werden.

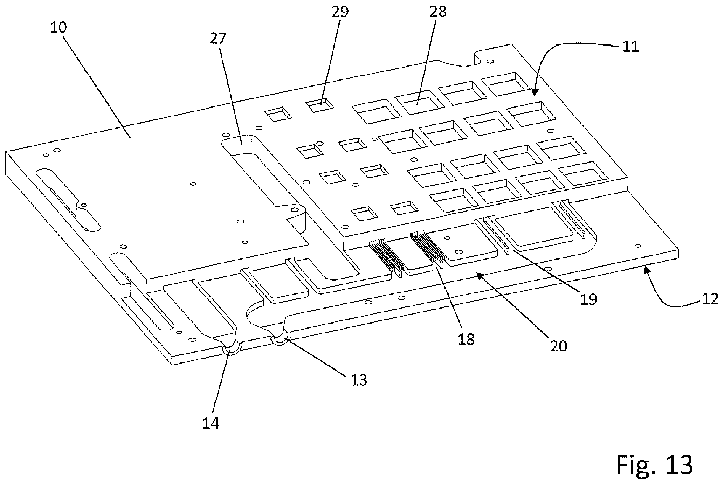

Figur 13 zeigt einen Kühlkörper 10 in einem zweiten Ausführungsbeispiel. Im zweiten Ausführungsbeispiel sind in der oberseitigen Oberfläche 11 taschenförmige Ausnehmungen 28 für die Elektronikelemente 3a und taschenförmige Ausnehmungen 29 für die Elektronikelemente 3b geformt. Die Ausnehmungen 28 sind an die äußeren Oberflächen der Elektronikelemente 3a und die Ausnehmungen 29 sind an die äußeren Oberflächen der Elektronikelemente 3b angepasst geformt, um die zugeordneten Elektronikelemente 3a und 3b aufnehmen zu können.

Im zweiten Ausführungsbeispiel werden die betreffenden Elektronikelemente 3a und 3b in den Kühlkörper 10 vergraben, vorzugsweise über Kopf, angeordnet. In einer Über-Kopf-Anordnung weisen die Unterseiten von über Kopf angeordneten Elektronikelementen 3a und 3b von der oberseitigen Oberfläche 11 weg, so dass im Bereich der Unterseiten vorgesehene elektrische Kontakte der Elektronikelemente 3a und 3b vom Kühlkörper 10 abgewandt sind. Vergrabene Elektronikelemente 3a und 3b ragen mit ihren von elektrischen Kontakten abgewandten Oberseiten sowie angrenzenden Seitenflächen in die jeweils zugeordnete Ausnehmung 28 oder 29. Die vergraben angeordneten Elektronikelemente 3a und 3b sind im Bereich ihrer oberseitigen Oberflächen thermisch leitend mit der Bodenfläche der zugeordneten Ausnehmung 28 oder 29 und/oder an ihren in die Ausnehmungen 28 und 29 hineinragenden Seitenflächen mit den entsprechenden Seitenflächen der Ausnehmungen 28 und 29 thermisch leitend verbunden. Die vergrabene Anordnung ermöglicht eine Wärmeübertragung zwischen dem Kühlkörper 10 und dem jeweiligen Elektronikelement 3a und/oder 3b auf besonders kurzem Übertragungsweg. Entsprechend effektiv kann die Wärme abgeführt werden. Sind die Elektronikelemente 3a und 3b wie bevorzugt und beispielsweise in Figur 1 illustriert auf einer Platine angeordnet, befinden sich die Elektronikelemente 3a und 3b bei vergrabener Anordnung zwischen dem Kühlkörper 10 und der Platine.

Die Elektronikelemente 3c des zweiten Layouts können bei beidseitiger Bestückung des Kühlkörpers 10 ebenfalls vergraben angeordnet sein. In der unterseitigen Oberfläche 12 wären in derartigen Ausführungen an die Elektronikelemente 3c geometrisch angepasste Ausnehmungen vorgesehen.

In Modifikationen kann auch nur eines oder können mehrere, aber nicht jedes der Elektronikelemente 3a und 3b und/oder eines oder mehrere, aber nicht jedes der Elektronikelemente 3c wie erläutert vergraben in einer oder mehreren geometrisch angepasst geformten Ausnehmungen aufgenommen sein.

Eine oder mehrere der Ausnehmungen, im Beispiel die Ausnehmungen 28 und 29, können wie in Figur 13 dargestellt in Draufsicht auf die oberseitige Oberfläche 11 in Überlappung zu Kanälen des Kanalsystems 20 angeordnet sein. Anstelle der Überlappung in Draufsicht kann eine oder können mehrere Ausnehmungen für die Aufnahme von vergraben angeordneten Elektronikelementen zwischen benachbarten Kanälen angeordnet und orthogonal zur Draufsicht auf die oberseitige Oberfläche 11 mit einem benachbarten Kanal überlappen. So könnte in Figur 13 beispielsweise eine Reihe von Ausnehmungen 28 und/oder eine Reihe von Ausnehmungen 29 vergleichbar der Ausnehmung 27 als Durchbrüche gebildet und zwischen zwei benachbarten Kanälen des Kanalsystems 20 angeordnet sein. In derartigen Ausführungen wären in den jeweiligen Durchbruch ragende Elektronikelemente an ihren Seitenflächen wärmeleitend mit zugewandten Seitenflächen des jeweiligen Durchbruchs verbunden. Bei taschenförmiger Ausbildung von Ausnehmungen kann jedoch ein großflächigerer Wärmeaustausch verwirklicht werden.

## Patentansprüche

1. Elektronikmodul mit einem Kühlkörper (10), der vorzugsweise eine Kühlplatte ist, und Elektronikelementen (3a, 3b), die über eine oberseitige Oberfläche (11) des Kühlkörpers (10) verteilt angeordnet, in einem ersten Layout (1) untereinander mittels Leiterbahnen verbunden und zur Kühlung mit der oberseitigen Oberfläche (11) und/oder mit einer oder mehreren seitlichen Oberflächen einer oder mehrerer optionalen Ausnehmungen (28, 29) des Kühlkörpers (10) thermisch gekoppelt sind, der Kühlkörper (10) umfassend:
(a) einen Einlass (13) für ein Kühlfluid,
(b) einen Auslass (14) für das Kühlfluid
(c) und ein den Kühlkörper (10) durchziehendes Kanalsystem (20) mit im Inneren des Kühlkörpers (10) verzweigten Kanälen (15-19, 21-24), die den Einlass (13) mit dem Auslass (14) verbinden, damit das Kühlfluid vom Einlass zum Auslass strömen kann,
(d) wobei der Kühlkörper (10) generativ als Monolith erzeugt ist
**dadurch gekennzeichnet, dass**
(e) eine innere Oberfläche bei einem, mehreren oder bei sämtlichen Kanälen durch eine bei der generativen Erzeugung geschaffene Strukturierung der inneren Oberfläche deutlich vergrößert ist, um einen thermischen Übergang pro Flächeneinheit der oberseitigen Oberfläche zu vergrößern und/oder in bestimmten Flächenbereichen zu konzentrieren,
(f) wobei in einem oder mehreren der Kanäle (15-19, 21-24) ein(e) oder mehrere Kühlpins und/oder Kühlfinnen (26) geformt ist oder sind.

2. Elektronikmodul nach dem vorhergehenden Anspruch, umfassend ein aus mehreren Gehäuseteilen (4, 5, 6, 7) gefügtes Gehäuse (4-7), in dem die Elektronikelemente (3a, 3b) und der Kühlkörper (10) angeordnet sind, wobei die Elektronikelemente (3a, 3b) am Kühlkörper (10) angeordnet sind und der Kühlkörper (10) im Gehäuse (4-8) montiert ist und wobei eines oder mehrere der Gehäuseteile (4, 5, 6, 7) vorzugsweise mittels Gießen, Strangpressen, Extrusion, Pressen und Sintern, Umformung oder mittels Zerspanung gefertigt ist oder sind.

3. Elektronikmodul nach einem der vorhergehenden Ansprüche, umfassend weitere Elektronikelemente (3c), die über eine der oberseitigen Oberfläche (11) abgewandt gegenüberliegende unterseitige Oberfläche (12) des Kühlkörpers (10) verteilt angeordnet, in einem zweiten Layout (2) untereinander mittels Leiterbahnen verbunden und zur Kühlung mit der unterseitigen Oberfläche (12) thermisch gekoppelt sind.

4. Elektronikmodul nach einem der vorhergehenden Ansprüche, wobei das Kanalsystem (20) dem ersten Layout (1) und, falls das Elektronikmodul die weiteren Elektronikelemente (3c) nach dem vorhergehenden Anspruch aufweist, vorzugsweise auch dem zweiten Layout (2) geometrisch angepasst ist, wobei einer oder mehrere der Kanäle (15-19, 21, 22) jeweils vorzugsweise mit einem oder mehreren der Elektronikelemente (3a, 3b; 3a, 3b, 3c) überlappen und/oder dem Verlauf einer der Leiterbahnen folgen.

5. Elektronikmodul nach einem der vorhergehenden Ansprüche, wobei das Kanalsystem (20) einen ersten Kanal (21) und einen stromabwärts des Einlasses (13) vom ersten Kanal (21) abzweigenden zweiten Kanal (15) sowie optional einen oder mehrere vom ersten Kanal (21) oder vom zweiten Kanal (15) abzweigende weitere Kanäle (16-19) umfasst und die Kanäle (15-19, 21-24) stromaufwärts des Auslasses (14) wieder zusammengeführt werden.

6. Elektronikmodul nach dem vorhergehenden Anspruch, wobei das Kanalsystem (20) einen vom ersten Kanal (21) oder vom zweiten Kanal (15) abzweigenden dritten Kanal (16) umfasst, der einen anderen Strömungswiderstand als der erste Kanal (21) und/oder der zweite Kanal (15) aufweist, wobei der Strömungswiderstand über die gesamte Länge des jeweiligen Kanals (15, 16, 21) gemessen wird.

7. Elektronikmodul nach einem der vorhergehenden Ansprüche, wobei das Kanalsystem (20) in Draufsicht auf die oberseitige Oberfläche (11) des Kühlkörpers (10) einen linken Kanal (15), einen rechten Kanal (17) und einen zwischen dem linken Kanal (15) und dem rechten Kanal (17) erstreckten, dem linken Kanal (15) und dem rechten Kanal (17) jeweils nächst benachbarten mittleren Kanal (16) umfasst und in der Draufsicht ein Abstand zwischen dem mittleren Kanal (16) und dem linken Kanal (15) größer oder kleiner als ein Abstand zwischen dem mittleren Kanal (16) und dem rechten Kanal (17) ist.

8. Elektronikmodul nach einem der vorhergehenden Ansprüche, wobei das Kanalsystem (20) zwei oder mehr Kanäle (15-19, 22, 24) aufweist, die in Draufsicht auf die oberseitige Oberfläche (11) zueinander versetzt sind, und zwei oder mehr Kanäle aufweist, die in eine parallel zur Richtung der Draufsicht weisende Dickenrichtung zueinander versetzt sind.

9. Elektronikmodul nach einem der vorhergehenden Ansprüche, wobei der ein(e) oder die mehreren Kühlpins und/oder Kühlfinnen (26) als in die jeweilige Kanallängsrichtung erstreckte Kühlrippe(n) geformt ist oder sind.

10. Elektronikmodul nach einem der vorhergehenden Ansprüche, wobei der Kühlkörper (10) zumindest im Wesentlichen aus einer Metalllegierung besteht, deren chemische Zusammensetzung in Draufsicht auf die oberseitige Oberfläche (11) in Längsrichtung und/oder Breitenrichtung des Kühlkörpers (10) und/oder bevorzugt orthogonal zur Längsrichtung und zur Breitenrichtung in Dickenrichtung des Kühlkörpers (10) variiert.

11. Elektronikmodul nach einem der vorhergehenden Ansprüche, wobei der Kühlkörper (10) in der oberseitigen Oberfläche (11) eine oder mehrere Ausnehmungen (27) aufweist, wobei sich die eine oder wenigstens eine von mehreren Ausnehmungen (27) in Draufsicht auf die oberseitige Oberfläche (11) vorzugsweise zwischen benachbarten Kanälen (16, 17) erstreckt und/oder in einer zur Richtung der Draufsicht orthogonalen Projektion vorzugsweise mit wenigstens einem der benachbarten Kanäle (16, 17) überlappt.

12. Elektronikmodul nach einem der vorhergehenden Ansprüche, wobei der Kühlkörper (10) in der oberseitigen Oberfläche (11) wenigstens eine Ausnehmung (28, 29) aufweist und wenigstens eines der Elektronikelemente (3a, 3b; 3a, 3b, 3c) in die wenigstens eine Ausnehmung (28, 29) ragt und in der Ausnehmung (28, 29) thermisch leitend mit dem Kühlkörper (10) verbunden ist.

13. Verfahren zur Herstellung eines Kühlkörpers für ein Elektronikmodul nach einem der Ansprüche 1 bis 12, der Kühlkörper (10) umfassend:
- einen Einlass (13) für ein Kühlfluid,
- einen Auslass (14) für das Kühlfluid,
- ein den Kühlkörper (10) durchziehendes Kanalsystem (20) mit im Inneren des Kühlkörpers (10) verzweigten, den Einlass (13) mit dem Auslass (14) verbinden Kanälen (15-19, 21-24),
- eine für das Kühlfluid dichte Deckschicht mit einer oberseitigen äußeren Oberfläche (11)
- und eine für das Kühlfluid dichte weitere Deckschicht mit einer der oberseitigen Oberfläche abgewandt gegenüberliegenden äußeren unterseitigen Oberfläche (12),
(a) wobei der Kühlkörper (10) im Ganzen generativ durch Auftragen von Metallpulver in Pulverbettschichten und Verfestigen von Metallpulver der jeweiligen Pulverbettschicht erzeugt wird, indem
(b) das Metallpulver in der jeweiligen Pulverbettschicht der Geometrie des Kanalsystems (20), des Einlasses (13) und des Auslasses (14) entsprechend
(c) und in um das Kanalsystem (20) erstreckten Außenbereichen den Deckschichten entsprechend selektiv mittels Energiestrahl, vorzugsweise Laser, verfestigt und dadurch das Kanalsystem (20) zwischen den Deckschichten dicht eingeschlossen wird,
(d) wobei eine innere Oberfläche bei einem, mehreren oder bei sämtlichen Kanälen (15-19, 21-24) durch eine bei der generativen Erzeugung geschaffene Strukturierung der inneren Oberfläche deutlich vergrößert wird, um einen thermischen Übergang pro Flächeneinheit der oberseitigen Oberfläche zu vergrößern und/oder in bestimmten Flächenbereichen zu konzentrieren,
(e) wobei in einem oder mehreren der Kanäle (15-19, 21-24) ein(e) oder mehrere Kühlpins und/oder Kühlfinnen (26) geformt ist oder sind.

14. Verfahren nach dem vorhergehenden Anspruch, bei dem
- die Verlustleistungen der Elektronikelemente (3a, 3b) ermittelt,
- die Geometrie des Kanalsystems (20) auf die topographische Verteilung der Verlustleistungen (D) abgestimmt
- und das Metallpulver der geometrischen Abstimmung entsprechend selektiv verfestigt wird.

15. Verfahren nach einem der zwei unmittelbar vorhergehenden Ansprüche, bei dem die Pulverbettschichten selektiv jeweils in Pulverstreifen verfestigt und der Kühlkörper (10) in Form einer Kühlplatte oder -schale mit der oberseitigen Oberfläche (11) und der unterseitigen Oberfläche (12) stehend mit längs diesen Oberflächen (11, 12) fortschreitendem Schichtaufbau erzeugt wird.

16. Verfahren nach einem der drei unmittelbar vorhergehenden Ansprüche, bei dem eine chemische Zusammensetzung des Metallpulvers in Richtung des Schichtaufbaus verändert wird, um den Kühlkörper (10) zumindest bereichsweise in einem Gradientenwerkstoff zu erzeugen.

## Claims

1. Electronic module having a heat sink (10), which is preferably a cooling plate, and electronic elements (3a, 3b) which are arranged distributed over an upper surface (11) of the heat sink (2)), are connected to each other in a first layout (1) by means of strip conductors and are thermally coupled to the upper surface (11) and/or to one or more side surfaces of one or more optional recesses (28, 29) of the heat sink (10) for cooling purposes, the heat sink (10) comprising:
(a) an inlet (13) for a cooling fluid,
(b) an outlet (14) for the cooling fluid,
(c) and a channel system (20) running through the heat sink (10) and having channels (15-19, 21-24) branched-off within the heat sink (10) and connecting the inlet (13) to the outlet (14) so that the cooling fluid can flow from the inlet to the outlet,
(d) wherein the heat sink (10) is produced generatively as a monolith,
**characterised in that**
(e) an inner surface in one, more or all channel (s) is enlarged considerably by a structuring of the inner surface created during the generative production in order to increase a thermal transition per unit area of the upper surface and/or to concentrate same in particular surface regions,
(f) wherein one or more cooling pins and/or cooling fins (26) is/are formed in one or more of the channels (15-19, 21-24) .

2. Electronic module as claimed in the preceding claim, comprising a housing (4-7) assembled from several housing parts (4, 5, 6, 7), in which housing the electronic elements (3a, 3b) and the heat sink (10) are arranged, wherein the electronic elements (3a, 3b) are arranged on the heat sink (10) and the heat sink (10) is mounted in the housing (4-8), and wherein one or more of the housing parts (4, 5, 6, 7) is/are preferably produced by means of casting, extrusion moulding, extrusion, compacting and sintering, deformation or by means of chip removal.

3. Electronic module as claimed in any one of the preceding claims, comprising further electronic elements (3c) which are arranged distributed over a lower surface (12) of the heat sink (10) opposite to and facing away from the upper surface (11), are connected to each other in a second layout (2) by means of strip conductors and are thermally coupled to the lower surface (12) for cooling purposes.

4. Electronic module as claimed in any one of the preceding claims, wherein the channel system (20) is geometrically adapted to the first layout (1) and, if the electronic module comprises the further electronic elements (3c) as claimed in the preceding claim, preferably also to the second layout (2), wherein one or more of the channels (15-19, 21-22) each preferably overlap one or more of the electronic elements (3a, 3b; 3a, 3b, 3c) and/or follow the path of one of the strip conductors.

5. Electronic module as claimed in any one of the preceding claims, wherein the channel system (20) comprises a first channel (21) and a second channel (15) branching off from the first channel (21) downstream of the inlet (13), and optionally one or more further channels (16-19) branching off from the first channel (21) or from the second channel (15), and the channels (15-19, 21-24) reconverge upstream of the outlet (14).

6. Electronic module as claimed in the preceding claim, wherein the channel system (20) comprises a third channel (16) branching off from the first channel (21) or from the second channel (15), said third channel having a flow resistance different from that of the first channel (21) and/or the second channel (15), wherein the flow resistance is measured over the entire length of the respective channel (15, 16, 21).

7. Electronic module as claimed in any one of the preceding claims, wherein the channel system (20) comprises, as seen in plan view of the upper surface (11) of the heat sink (10), a left channel (15), a right channel (17) and a middle channel (16) extended between the left channel (15) and the right channel (17) and immediately adjacent to each of the left channel (15) and the right channel (17) and, in the plan view, a distance between the middle channel (16) and the left channel (15) is greater than or less than a distance between the middle channel (16) and the right channel (17).

8. Electronic module as claimed in any one of the preceding claims, wherein the channel system (20) comprises two or more channels (15-19, 22, 24) which, as seen in plan view of the upper surface (11), are offset with respect to each other, and comprises two or more channels which are offset with respect to each other in a thickness direction in parallel with the direction of the plan view.

9. Electronic module as claimed in any one of the preceding claims, wherein the one or more cooling pins and/or cooling fins (26) is/are formed as cooling rib(s) extended in the respective channel longitudinal direction.

10. Electronic module as claimed in any one of the preceding claims, wherein the heat sink (10) at least substantially consists of a metal alloy, the chemical composition of which varies, as seen in plan view of the upper surface (11), in the longitudinal direction and/or width direction of the heat sink (10) and/or preferably orthogonal to the longitudinal direction and to the width direction in the thickness direction of the heat sink (10).

11. Electronic module as claimed in any one of the preceding claims, wherein the heat sink (10) in the upper surface (11) comprises one or more recesses (27), wherein the one or at least one of several recesses (27), as seen in plan view of the upper surface (11), preferably extends between adjacent channels (16, 17) and/or preferably overlaps one of the adjacent channels (16, 17) in a projection orthogonal to the direction of the plan view.

12. Electronic module as claimed in any one of the preceding claims, wherein the heat sink (10) in the upper surface (11) comprises at least one recess (28, 29) and at least one of the electronic elements (3a, 3b; 3a, 3b, 3c) protrudes into the at least one recess (28, 29) and is connected to the heat sink (10) in the recess (28, 29) in a thermally conductive manner.

13. Method for producing a heat sink for an electronic module as claimed in any one of claims 1 to 12, the heat sink (10) comprising:
- an inlet (13) for a cooling fluid,
- an outlet (14) for the cooling fluid,
- a channel system (20) running through the heat sink (10) and having channels (15-19, 21-24) branched-off within the heat sink (10) and connecting the inlet (13) to the outlet (14),
- a cover layer, impervious to the cooling fluid, having an upper, outer surface (11),
- and a further cover layer, impervious to the cooling fluid, having an outer, lower surface (12) opposite to and facing away from the upper surface,
(a) wherein the heat sink (10) is produced in its entirety generatively by applying metal powder in powder bed layers and compacting metal powder of the respective powder bed layer, in that
(b) the metal powder in the respective powder bed layer is compacted so as to correspond to the geometry of the channel system (20), of the inlet (13) and of the outlet (14),
(c) and in outer regions extended around the channel system (20), is compacted so as to correspond to the cover layers selectively by means of an energy beam, preferably a laser, and as a result the channel system (20) is tightly enclosed between the cover layers,
(d) wherein an inner surface in one, more or all channel(s) (15-19, 21-24) is enlarged considerably by a structuring of the inner surface created during the generative production in order to increase a thermal transition per unit area of the upper surface and/or to concentrate same in particular surface regions,
(e) wherein one or more cooling pins and/or cooling fins (26) is/are formed in one or more of the channels (15-19, 21-24) .

14. Method as claimed in the preceding claim, in which
- the power dissipation of the electronic elements (3a, 3b) is determined,
- the geometry of the channel system (20) is matched to the topographic distribution of the power dissipation (D),
- and the metal powder of the geometric matching is compacted accordingly selectively.

15. Method as claimed in any one of the two immediately preceding claims, in which the powder bed layers are each selectively compacted in powder strips and the heat sink (10) is produced in the form of a cooling plate or shell where the upper surface (11) and the lower surface (12) are upright with a layer structure which proceeds along these surfaces (11, 12).

16. Method as claimed in any one of the three immediately preceding claims, in which a chemical composition of the metal powder is changed in the direction of the layer structure in order to produce the heat sink (10) at least in regions in a functionally graded material.

## Revendications

1. Module électronique comportant un corps de refroidissement (10), lequel est de préférence une plaque de refroidissement, et des éléments électroniques (3a, 3b), lesquels sont disposés répartis sur une surface supérieure (11) du corps de refroidissement (10), sont reliés l'un à l'autre au moyen de pistes conductrices dans un premier agencement (1) et sont couplés thermiquement pour le refroidissement avec la surface supérieure (11) et/ou avec une ou plusieurs surfaces latérales d'un ou plusieurs évidements éventuels (28, 29) du corps de refroidissement (10), le corps de refroidissement (10) comprenant :
(a) une entrée (13) pour un fluide de refroidissement,
(b) une sortie (14) pour le fluide de refroidissement
(c) et un système de conduits (20) traversant le corps de refroidissement (10) et comportant des conduits (15-19, 21-24) ramifiés à l'intérieur du corps de refroidissement (10), lesquels relient l'entrée (13) à la sortie (14), de sorte que le fluide de refroidissement peut passer de l'entrée vers la sortie,
(d) dans lequel le corps de refroidissement (10) est fabriqué de manière générative comme monolithe,
**caractérisé en ce que**
(e) une surface intérieure pour un, plusieurs ou pour la totalité des conduits est significativement augmentée par une structuration obtenue lors de la fabrication générative, afin d'augmenter et/ou de concentrer dans des régions de surface déterminées un transfert thermique par unité de surface de la surface supérieure,
(f) dans lequel une ou plusieurs broche (s) de refroidissement et/ou lamelle (s) de refroidissement (26) est ou sont formée(s) dans un ou plusieurs des conduits (15-19, 21-24) .

2. Module électronique selon l'une des revendications précédentes, comprenant un boîtier (4-7) assemblés de plusieurs parties de boîtier (4, 5, 6, 7), à l'intérieur duquel sont disposés les éléments électroniques (3a, 3b) et le corps de refroidissement (10), dans lequel les éléments électroniques (3a, 3b) sont disposés au niveau du corps de refroidissement (10) et le corps de refroidissement (10) est monté dans le boîtier (4-8) et dans lequel une ou plusieurs des parties de boîtier (4, 5, 6, 7) est ou sont de préférence fabriqué(s) par moulage, boudinage, extrusion, pressage et frittage, formage ou par usinage.

3. Module électronique selon l'une des revendications précédentes, comprenant des éléments électroniques supplémentaires (3c), lesquels sont disposés répartis sur une surface inférieure (12) du corps de refroidissement (10), à l'opposé de la surface supérieure (11) et se détournant de celle-ci, sont reliés l'un à l'autre au moyen de pistes conductrices dans un deuxième agencement (2) et sont couplés thermiquement pour le refroidissement avec la surface inférieure (12).

4. Module électronique selon l'une des revendications précédentes, dans lequel le système de conduits (20) est géométriquement adapté au premier agencement (1) et, dans le cas où le module électronique comporte les éléments électroniques supplémentaires (3c) selon la revendication précédente, de préférence également au deuxième agencement (2), dans lequel un ou plusieurs des conduits (15-19, 21, 22) chevauchent de préférence respectivement un ou plusieurs des éléments électroniques (3a, 3b ; 3a, 3b, 3c) et/ou suivent le tracé d'une des pistes conductrices.

5. Module électronique selon l'une des revendications précédentes, dans lequel le système de conduits (20) comprend un premier canal (21) et un deuxième canal (15) dérivant du premier canal (21) en aval de l'entrée (13) de même, éventuellement, qu'un ou plusieurs conduits supplémentaires (16-19) dérivant du premier canal (21) ou du deuxième canal (15) et les conduits (15-19, 21-24) sont de nouveau réunis en amont de la sortie (14).

6. Module électronique selon la revendication précédente, dans lequel le système de conduits (20) comprend un troisième conduit (16) dérivant du premier conduit (21) ou du deuxième conduit (15), lequel présente une résistance à l'écoulement différente de celle du premier conduit (21) et/ou du deuxième conduit (15), dans lequel la résistance à l'écoulement est mesurée sur la totalité de la longueur du conduit respectif (15, 16, 21).

7. Module électronique selon l'une des revendications précédentes, dans lequel le système de conduits (20) comprend, en vue de dessus sur la surface supérieure (11) du corps de refroidissement (10), un conduit gauche (15), un conduit droit (17) et un conduit central (16) s'étendant entre le conduit gauche (15) et le conduit droit (17) et respectivement le plus proche du conduit gauche (15) et du conduit droit (17) et, en vue de dessus, une distance entre le conduit central (16) et le conduit gauche (15) est supérieure ou inférieure à une distance entre le conduit central (16) et le conduit droit (17) .

8. Module électronique selon l'une des revendications précédentes, dans lequel le système de conduits (20) comporte deux ou plus conduits (15-19, 22, 24), lesquels sont décalés l'un par rapport à l'autre, en vue de dessus sur la surface supérieure (11), et deux ou plus conduits, lesquels sont décalés l'un par rapport à l'autre dans une direction d'épaisseur orientée parallèlement à la direction de la vue de dessus.

9. Module électronique selon l'une des revendications précédentes, dans lequel l'une ou les plusieurs broche(s) de refroidissement et/ou lamelle(s) de refroidissement (26) est ou sont formée(s) comme ailette (s) de refroidissement s'étendant dans la direction longitudinale de conduit respective.

10. Module électronique selon l'une des revendications précédentes, dans lequel le corps de refroidissement (10) est constitué au moins sensiblement d'un alliage métallique, dont la composition chimique, en vue de dessus sur la surface supérieure (11), varie dans la direction longitudinale et/ou dans la direction de la largeur du corps de refroidissement (10) et/ou de préférence dans la direction de l'épaisseur du corps de refroidissement (10), orthogonale à la direction longitudinale et à la direction de la largeur.

11. Module électronique selon l'une des revendications précédentes, dans lequel le corps de refroidissement (10) comporte un ou plusieurs évidements (27) dans la surface supérieure (11), dans lequel l'un ou au moins un des plusieurs évidements (27), en vue de dessus sur la surface supérieure (11), s'étend de préférence entre des conduits adjacents (16, 17) et/ou chevauche de préférence au moins un des conduits adjacents (16, 17) dans une projection orthogonale à la direction de la vue de dessus.

12. Module électronique selon l'une des revendications précédentes, dans lequel le corps de refroidissement (10) comporte au moins un évidement (28, 29) dans la surface supérieure (11) et au moins un des éléments électroniques (3a, 3b ; 3a, 3b, 3c) fait saillie dans l'au moins un évidement (28, 29) et est relié au corps de refroidissement (10) dans l'évidement (28, 29) de manière thermiquement conductrice.

13. Procédé de fabrication d'un corps de refroidissement pour un module électronique selon l'une des revendications 1 à 12, le corps de refroidissement (10) comprenant :
- une entrée (13) pour un fluide de refroidissement,
- une sortie (14) pour le fluide de refroidissement,
- un système de conduits (20) traversant le corps de refroidissement (10) et doté de conduits (15-19, 21-24) ramifiés à l'intérieur du corps de refroidissement (10) et reliant l'entrée (13) à la sortie (14),
- une couche de revêtement étanche au fluide de refroidissement, dotée d'une surface supérieure (11) externe,
- et une couche de revêtement supplémentaire étanche au fluide de refroidissement dotée d'une surface inférieure (12) externe à l'opposé de la surface supérieure et se détournant de celle-ci,
(a) dans lequel le corps de refroidissement (10) est dans l'ensemble fabriqué de manière générative par application de poudre métallique dans des couches de lit de poudre et solidification de la poudre métallique de la couche de lit de poudre respective,
(b) en solidifiant la poudre métallique de la couche de lit de poudre respective d'une manière correspondant à la géométrie du système de conduits (20), de l'entrée (13) et de la sortie (14)
(c) et en solidifiant d'une manière correspondant aux couches de revêtement dans les zones extérieures s'étendant autour du système de conduits (20), sélectivement au moyen d'un faisceau d'énergie, de préférence d'un laser, et en enfermant ainsi de façon étanche le système de conduits (20) entre les couches de revêtement,
(d) dans lequel une surface intérieure pour un, plusieurs ou pour la totalité des conduits (15-19, 21-24) est significativement augmentée par une structuration obtenue lors de la fabrication générative, afin d'augmenter et/ou de concentrer dans des régions de surface déterminées un transfert thermique par unité de surface de la surface supérieure,
(e) dans lequel une ou plusieurs broche (s) de refroidissement et/ou lamelles de refroidissement (26) est ou sont formée(s) dans un ou plusieurs des conduits (15-19, 21-24) .

14. Procédé selon la revendication précédente, dans lequel
- les pertes de puissance des éléments électroniques (3a, 3b) sont déterminées,
- la géométrie du système de conduits (20) est coordonnée à la distribution topographique des pertes de puissance (D)
- et la poudre métallique est sélectivement solidifiée de manière correspondant à la coordination géométrique.

15. Procédé selon l'une des deux revendications immédiatement précédentes, dans lequel les couches de lit de poudre sont respectivement solidifiées sélectivement en bandes de poudre et le corps de refroidissement (10) est fabriqué sous forme d'une plaque de refroidissement ou d'une coque de refroidissement avec la surface supérieure (11) et la surface inférieure (12) verticales avec un arrangement progressif des couches le long de ces surfaces (11, 12).

16. Procédé selon l'une des trois revendications immédiatement précédentes, dans lequel une composition chimique de la poudre métallique est modifiée dans la direction de la structure des couches, afin de fabriquer le corps de refroidissement (10) au moins par sections dans un matériau à gradient.
